(19) 

Europäisches Patentamt

European Patent Office

Office européen des brevets

(11) **EP 4 436 049 A1**

(12) **EUROPEAN PATENT APPLICATION**

(43) Date of publication:
**25.09.2024 Bulletin 2024/39**

(21) Application number: **24164788.2**

(22) Date of filing: **20.03.2024**

(51) International Patent Classification (IPC):
**H03M 7/30** (2006.01)  **H04N 25/00** (2023.01)
**H04N 25/50** (2023.01)

(52) Cooperative Patent Classification (CPC):
**H04N 25/00; H04N 25/50**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.03.2023 US 202363454600 P**
**20.04.2023 US 202318304295**

(71) Applicant: **Samsung Electronics Co., Ltd.**
**Suwon-si, Gyeonggi-do 16677 (KR)**

(72) Inventors:
• **WANG, Yibing Michelle**
**San Jose, CA, 95134 (US)**
• **REN, Yanhai**
**San Jose, CA, 95134 (US)**

(74) Representative: **Kuhnen & Wacker**
**Patent- und Rechtsanwaltsbüro PartG mbB**
**Prinz-Ludwig-Straße 40A**
**85354 Freising (DE)**

(54) **SYSTEM AND METHOD FOR SHUTTER CONTROL**

(57) A system and method for shutter control. In some embodiments, the system includes: a pixel array for imaging; and a shutter control signal generator circuit, the shutter control signal generator circuit being configured: to control shutters of a first subarray of the pixel array with a first set of control signals, and to control shutters of a second subarray of the pixel array with the first set of control signals.

FIG. 1

# Description

## FIELD

One or more aspects of embodiments according to the present disclosure relate to imaging, and more particularly to a system and method for shutter control.

## BACKGROUND

Spatial and temporal compression may be performed in an image acquisition system (e.g., in a video camera) by enabling and disabling the pixels of a pixel array individually or in groups while an image is being acquired.

It is with respect to this general technical environment that aspects of the present disclosure are related.

## SUMMARY

According to an embodiment of the present disclosure, there is provided a system, including: a pixel array for imaging; and a shutter control signal generator circuit, the shutter control signal generator circuit being configured: to control shutters of a first subarray of the pixel array with a first set of control signals, and to control shutters of a second subarray of the pixel array with the first set of control signals.

In some embodiments, wherein the shutter control signal generator circuit has h outputs, h being a positive integer, a first one of the h outputs being: connected to a first row of the first subarray, and connected to a first row of the second subarray.

In some embodiments: the first row of the first subarray is a row of pixels; and the first row of the second subarray is a row of pixels.

In some embodiments: the first subarray includes w flip flops configured as a shift register, w being a positive integer; each of the w flip flops is in a respective pixel of a first row of pixels of the first subarray; a first flip flop of the w flip flops is connected to an output of the h outputs of the shutter control signal generator circuit; and a second flip flop of the w flip flops is connected to an output of the first flip flop.

In some embodiments, the shutter control signal generator circuit has h $\times$ w outputs, w being a positive integer, each of the h $\times$ w outputs being connected to: a respective pixel of the first subarray, and a respective pixel of the second subarray.

In some embodiments, the first row of the first subarray is a row of macro blocks.

In some embodiments: the first subarray includes w flip flops configured as a shift register, w being a positive integer; each of the w flip flops is in a respective macro block of the first row of the first subarray; a first flip flop of the w flip flops is connected to an output of the h outputs of the shutter control signal generator circuit;

and a second flip flop of the w flip flops is connected to an output of the first flip flop.

In some embodiments: a first pixel of a first macro block of the row of macro blocks is configured to receive a first signal; and a second pixel of the first macro block is configured to receive a second signal, the second signal being a complement of the first signal.

In some embodiments: the first macro block includes four pixels, and two of the four pixels receive the first signal and two of the four pixels receive the second signal.

In some embodiments: the first macro block includes four pixels, and three of the four pixels receive the first signal and one of the four pixels receives the second signal.

In some embodiments: the first row of the second subarray is a row of macro blocks; and the shutter control signal generator circuit has h x w outputs, w being a positive integer, each of the h $\times$ w outputs being connected to: a respective macro block of the first subarray, and a respective macro block of the second subarray.

In some embodiments: a first pixel of a first macro block is connected to an output of the h outputs and configured to receive a first signal, the first signal being equal to an output signal from the output; and a second pixel is configured to receive a second signal, the second signal being a complement of the first signal.

In some embodiments: the first macro block includes four pixels, and two of the four pixels receive the first signal and two of the four pixels receive the second signal.

In some embodiments: the first macro block includes four pixels, and three of the four pixels receive the first signal and one of the four pixels receives the second signal.

In some embodiments, the pixel array is configured: to combine outputs of pixels of a pixel readout block including a plurality of pixels, and to read out the combined output.

In some embodiments: the first row of the first subarray is a row of macro blocks; and the pixel readout block contains the same pixels as a first macro block of the row of macro blocks.

In some embodiments: the first row of the first subarray is a row of macro blocks; and the pixel readout block contains: a pixel included in a first macro block of the row of macro blocks, and a pixel included in a second macro block of the row of macro blocks.

According to an embodiment of the present disclosure, there is provided a method, including: controlling, with a first set of control signals, by a shutter control signal generator circuit, shutters of a first subarray of a pixel array for imaging, and controlling, with the first set of control signals, by the shutter control signal generator circuit, shutters of a second subarray of the pixel array.

In some embodiments, the shutter control signal generator circuit has h outputs, h being a positive integer, a first one of the h outputs being: connected to a first row of the first subarray, and connected to a first row of the second subarray.

According to an embodiment of the present disclosure, there is provided a system, including: a pixel array for imaging; and a means for shutter control, the means for shutter control being configured: to control shutters of a first subarray of the pixel array with a first set of control signals, and to control shutters of a second subarray of the pixel array with the first set of control signals.

## BRIEF DESCRIPTION OF THE DRAWINGS

These and other features and advantages of the present disclosure will be appreciated and understood with reference to the specification, claims, and appended drawings wherein:

FIG. 1 is a system block diagram, according to an embodiment of the present disclosure;

FIG. 2A is a block diagram of a shutter control and pixel readout scheme, according to an embodiment of the present disclosure;

FIG. 2B is an equivalent circuit diagram of a pixel, according to an embodiment of the present disclosure;

FIG. 3 is a schematic diagram of a shutter control signal generator circuit, according to an embodiment of the present disclosure;

FIG. 4A is a schematic drawing of a configuration for shutter control, according to an embodiment of the present disclosure;

FIG. 4B is a schematic drawing of a configuration for shutter control, according to an embodiment of the present disclosure;

FIG. 4C is a schematic drawing of a configuration for shutter control, according to an embodiment of the present disclosure;

FIG. 4D is a schematic drawing of a configuration for shutter control, according to an embodiment of the present disclosure;

FIG. 5 is an illustration of various configurations for shutter control within a macro block, according to an embodiment of the present disclosure; and

FIG. 6 is a schematic drawing of a configuration for readout according to pixel readout blocks, according to an embodiment of the present disclosure.

## DETAILED DESCRIPTION

The detailed description set forth below in connection with the appended drawings is intended as a description of exemplary embodiments of a system and method for shutter control provided in accordance with the present disclosure and is not intended to represent the only forms in which the present disclosure may be constructed or utilized. The description sets forth the features of the present disclosure in connection with the illustrated embodiments. It is to be understood, however, that the same or equivalent functions and structures may be accomplished by different embodiments that are also intended to be encompassed within the scope of the disclosure. As denoted elsewhere herein, like element numbers are intended to indicate like elements or features.

Various types of imaging, including motion-blur free low light imaging, high dynamic range (HDR) imaging, high speed imaging, and time-of-flight (TOF) imaging all have operations in common, such as the capturing of multiple frames with short integration times. These operations may generate large amounts of data and the data may need to be transferred and processed in a short period of time, increasing the challenges of meeting memory, processing speed and bandwidth requirements.

The images captured in such scenarios may have significant redundancy and be capable of being compressed efficiently. Based on compressed sensing theory it may be possible to compress the data at the pixel level before readout. This may potentially reduce both power consumption and the required bandwidth. To perform temporal compression, each exposure (which may be defined as the interval between successive points in time at which the pixel array is read out) may include a plurality of sub-exposures, each sub-exposure having a different subset of pixels for which the electronic shutters are open (the remainder of the electronic shutters being closed). To perform spatial compression, the pixels may be read out in groups (which may be referred to as "pixel readout blocks"). Temporal and spatial compression may both be performed in a single exposure, by combining these techniques. The image may then be reconstructed either on-chip or off-chip (e.g., using a suitable machine learning model) to recover the original multi-frame information.

To support temporal or spatial compressed sensing, a time varying, e.g., random per-pixel shutter control may be used. The shutter control signals may be switched at high speed for high frame rate output. Applying an independent shutter control signal for each pixel of each frame at high speed may be challenging considering the area and power consumption limitations of an image sensor. The difficulty of providing such a signal may increase for larger pixel arrays.

For example, some designs may use in-pixel memories or digital circuits to put all or part of the random generator inside the pixel to achieve per-pixel random shutter control. The implementation of such in-pixel memories or pseudo-random number generators (PRNGs) may occupy pixel area, which may reduce fill factor. Even if three-dimensional (3D) stacking is used, the in-pixel memories or pseudo-random number generators will limit pixel size, thus leading to a lower spatial resolution. Furthermore, the number of memories or PRNGs may increase with the number of pixels, which may also increase power consumption for a large pixel array.

Some designs stream shutter control signals into the pixel array in a serial manner. The drawback to such an approach is that it may take a long time to change masks, especially when the pixel array is large. As such, this approach may be unsuitable for highspeed imaging in which a high frame rate is required.

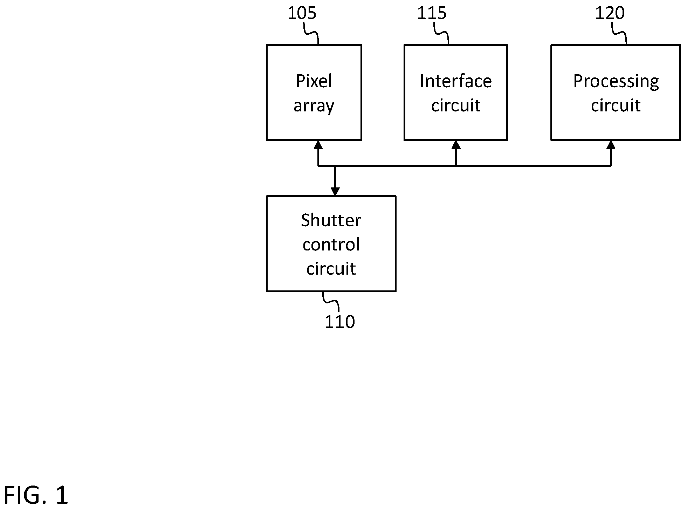

As such, in some embodiments, a dynamic in-pixel shutter control scheme as disclosed herein may be employed. Simple hardware may be used to implement such an embodiment and it may occupy little area. FIG. 1 shows a system for imaging, in some embodiments. A pixel array 105 is connected to a shutter control circuit 110 (or shutter control signal generator circuit 110), which may operate as a means for shutter control, and which supplies the shutter control signals that enable and disable the pixels of the pixel array. The pixel array 105 may be read out through an interface circuit 115 (which may include, e.g., one or more amplifiers and one or more analog to digital converters), by a processing circuit 120 (which may be digital circuit, as discussed in further detail below). The processing circuit 120 may also be connected to the shutter control signal generator circuit 110 and the processing circuit 120 may be configured to control the shutter control signal generator circuit 110.

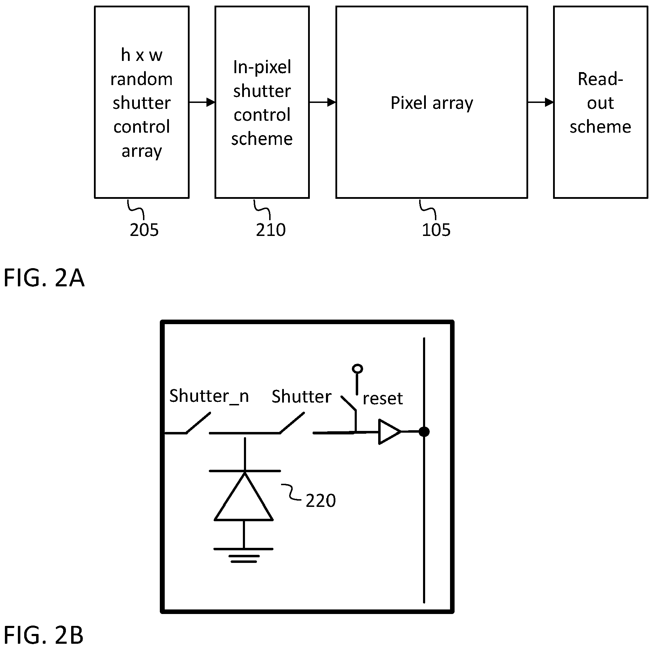

Referring to FIG. 2A, the shutter control signal generator circuit 110 may generate an h × w array of shutter control signals, which may be distributed or modified (as discussed in further detail below) in the pixel array 105 by an in-pixel shutter control scheme 210. A read-out scheme 215 may be used, at the end of each exposure, to read the pixels of the pixel array 105 individually, or (as discussed in further detail below) in pixel readout blocks. Referring to FIG. 2B, in some embodiments, each pixel may be modeled as including a detector (e.g., a photodetector 220) and two shutter switches, controlled by a shutter signal. When the shutter signal is high, a first switch (labeled "Shutter" in FIG. 2B) is closed (and a second switch, labelled "Shutter_n" in FIG. 2B. is open), and the signal (e.g., the photocurrent) corresponding to photons absorbed by the photodetector 220 is integrated (e.g., by a capacitor (not shown)).

When the shutter signal is low, the first switch is open and the second switch is closed, and the signal (e.g., the photocurrent) corresponding to photons absorbed by the photodetector 220 is discarded (e.g., shunted to ground). As such, the effect of the first switch and the second switch may be equivalent to that of a mechanical shutter that is open (allowing light to reach the photodetector 220) when the shutter signal is high (this state may be referred to as a state in which the electronic shutter is open), and that is closed (blocking any light that would otherwise reach the photodetector 220) when the shutter signal is low (this state may be referred to as a state in which the electronic shutter is closed). Once the pixel is read out, the integrator may be reset (e.g., the capacitor may be discharged), beginning a new exposure.

In some embodiments, for purposes of supplying shutter control signals, the pixel array 105 may be divided into a plurality of h × w subarrays (where h and w are integers at least one of which is greater than 1). The shutter signals for each h × w subarray of the pixel array 105 may be generated by the shutter control signal generator circuit 110; the same shutter control signals may be sent to all of the h × w subarrays, so that, for example, a first pixel in a first subarray may receive the same shutter control signal as the corresponding pixel in a second subarray. The shutter control signal generator circuit 110 may produce h × w shutter control signals, each of which may repeat after w updates. Mathematical font and normal font are used interchangeably herein, so that, for example, $h \times w$ and h × w are equivalent.

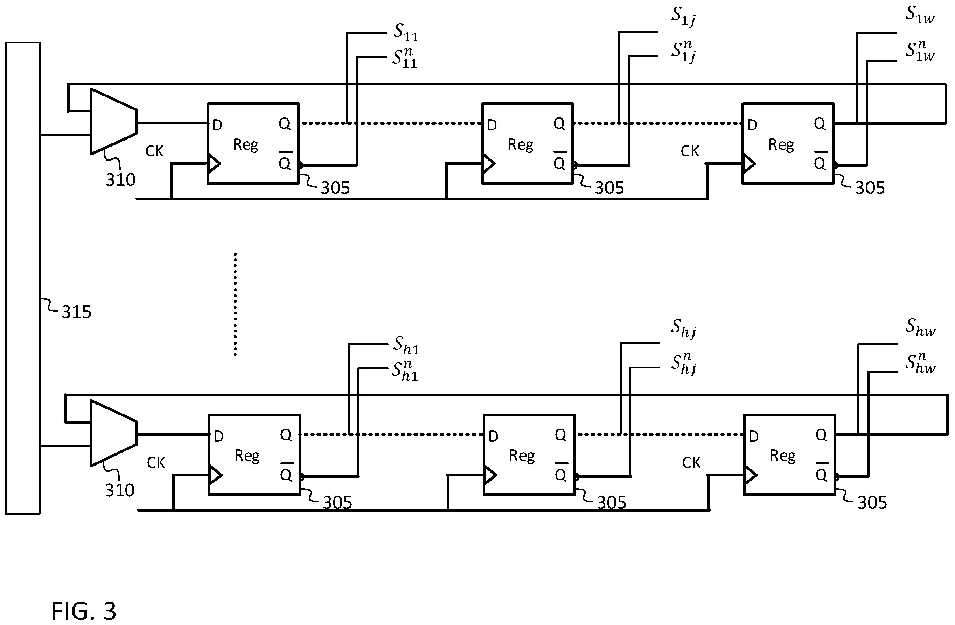

An example of a shutter control signal generator circuit 110 is illustrated in FIG. 3. It includes h circular shift registers, each including w flip flops 305 (dashed lines represent additional flip flops that may be present and that are not explicitly illustrated). At startup, a suitable (e.g., pseudo-random) sequence of bits may be shifted into each of the circular shift registers, by setting a respective multiplexer 310 to use, as the input of the first flip flop 305, the output of an initialization source 315 (which may be, for example, a memory or a pseudo-random number generator (PRNG). Once the sequence of bits has been shifted into each of the circular shift registers, each of the multiplexers 310 may be set to select, as the input of the corresponding first flip flop 305, the output of the corresponding last flip flop 305, causing each chain of flip flops 305 to operate as a circular shift register. The shutter control signal generator circuit 110 of FIG. 3 has h × w outputs $S_{11}$ through $S_{hw}$, and h × w corresponding complementary outputs $S_{11}^n$ through $S_{hw}^n$. Each of the output signals repeats every w updates (each of which may correspond to a clock cycle).

The following notation is used herein:

r denotes the temporal compression ratio ($r = kw$ where $k$ is a positive integer). r indicates the number of updates (e.g., flip flop clock cycles) in each exposure. $k$ indicates the number of times the sequence of $w$ updates is repeated during each exposure.

$h$ and $w$ denote the height and width, respectively, of each subarray (and of the array of output signals of the shutter control signal generator circuit 110).

$H$ and $W$ denote the height and width, respectively, of the pixel array.

$p$ denotes a subarray index.

$i, j$ denote the indices (or coordinates) of each pixel (or macro block (discussed in further detail below)) within each subarray.

$s$ denotes the size, in pixels, of each macro block.

$S_{ij}$, $S_{ij}^n$ denote the shutter control signal, and its complement, respectively, at location ($i, j$) within the array of output signals of the shutter control signal generator circuit 110.

$C_{ij}^{p}$ denotes an identifier of the configuration of macro block (i, j) in subarray p.

m denotes the size of the pixel readout block (and may be equal to the spatial compression ratio).

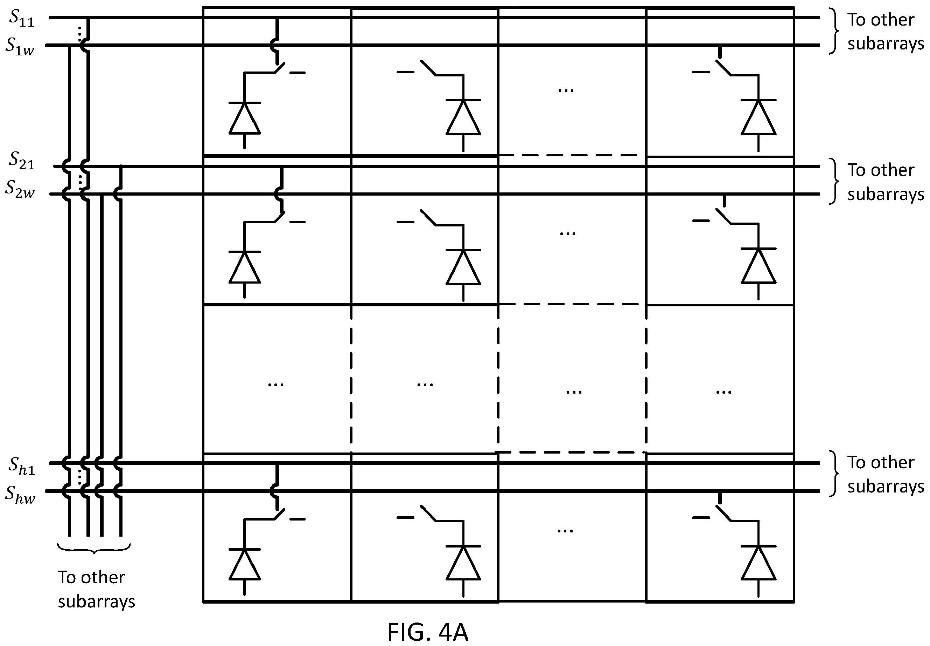

Within each subarray, the shutter control signal at pixel P(i, j) may come from $S_{ij}$ in the array of output signals of the shutter control signal generator circuit 110, namely $P_{ij}^{p} = S_{ij}$ for all subarrays p. The array of output signals of the shutter control signal generator circuit 110 may be directly wired to the pixel array 105, or shifted into the pixel array 105 (as discussed in further detail below). For example, FIG. 4A shows an embodiment in which the control signals are directly wired to the pixels of each subarray. FIG. 4A shows a first subarray. The control signals $S_{11}$ through $S_{hw}$ are fed to respective pixels of the first subarray, and also to the other subarrays of the pixel array 105. Any subarray that is smaller than h × w may not use all of the available control signals.

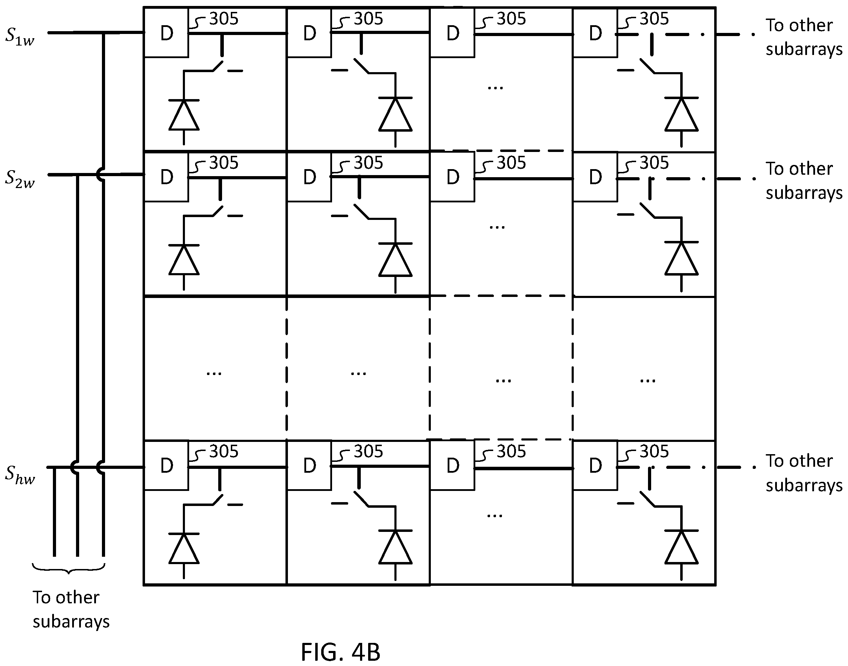

FIG. 4B shows an embodiment in which each pixel of the pixel array 105 includes a flip flop 305 having an input connected to either (i) the shutter control signal generator circuit 110 (for the left-most pixel of any row of the pixel array 105) or (ii) an output of the flip flop 305 of the pixel immediately to the left (for any other pixel of the pixel array 105). This configuration may cause each row of the pixel array 105 to operate as a shift register, shifting the data one pixel to the right with each clock cycle. At startup, in such an embodiment, the data from the shutter control signal generator circuit 110 may be shifted all the way across the pixel array 105 before image acquisition begins. Once the data from the shutter control signal generator circuit 110 have reached the last column of the pixel array 105, image acquisition may proceed, with the shutter control signals of all of the pixels of the pixel array 105 being updated as data are shifted, from the shutter control signal generator circuit 110 and across the pixel array 105.

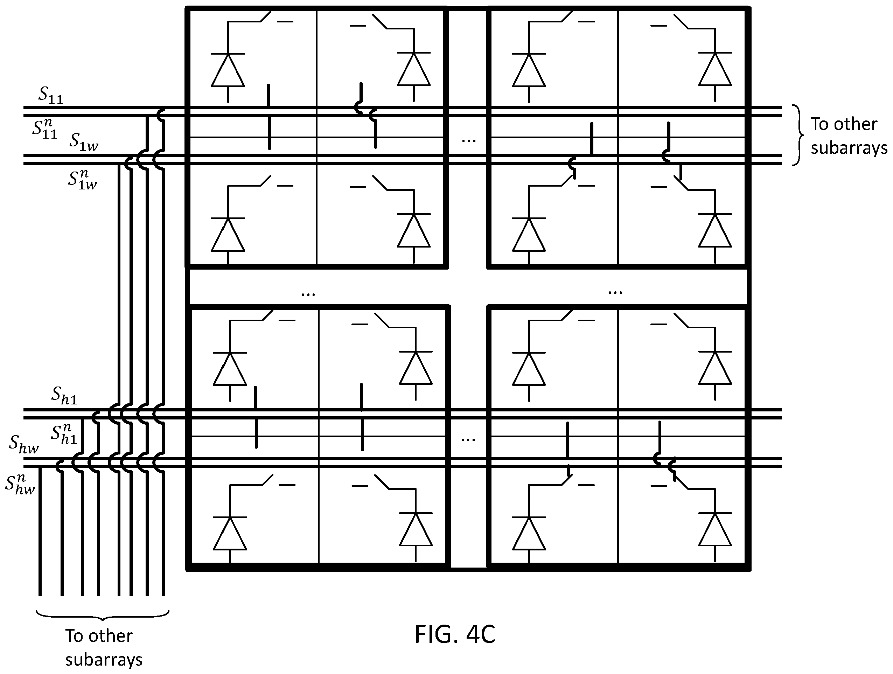

In some embodiments, pixels (e.g., adjacent pixels) may be grouped into groups referred to herein as "macro blocks" for purposes of shutter control. In such an embodiment, each pixel in the macro block receives either (i) the same sequence of shutter control signals as any other pixel in the macro block or (ii) the complementary sequence of shutter control signals. A circuit for implementing such a control scheme is shown in FIG. 4C. In the embodiment of FIG. 4C, the first macro block (at top left) receives the complementary control signals

$S_{11}$ and $S_{11}^{n}$. The signal $S_{11}$ controls the upper left and lower right pixels of the macro block, and its complement

$S_{11}^{n}$ controls the upper right and lower left pixels of the macro block. The embodiment of FIG. 4C is analogous to the embodiment of FIG. 4A in that, in both embodiments, the control signals are directly wired from the shutter control signal generator circuit 110 (in the embodiment of FIG. 4A the control signals are directly wired to the pixels of each subarray, and in the embodiment of FIG. 4C, the control signals are directly wired to the macro blocks of each subarray).

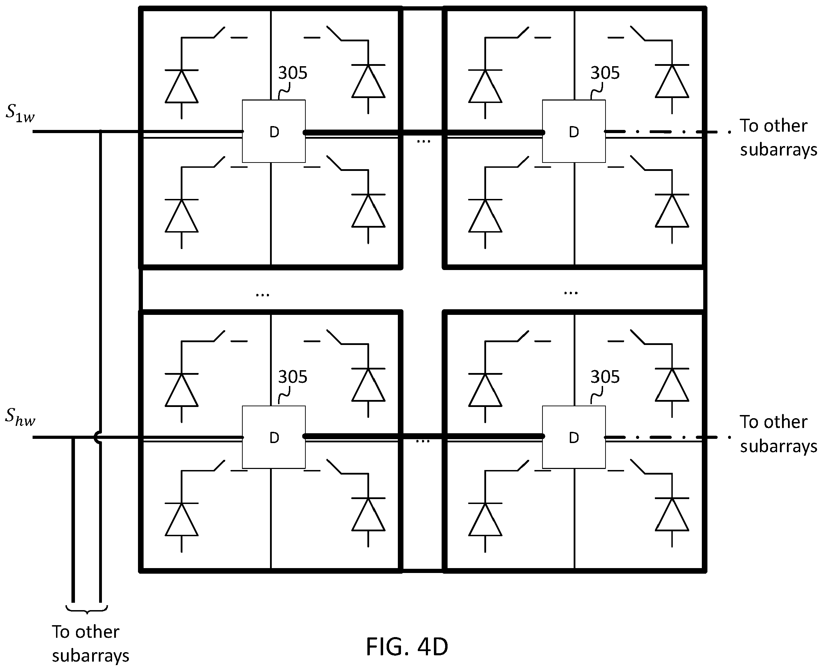

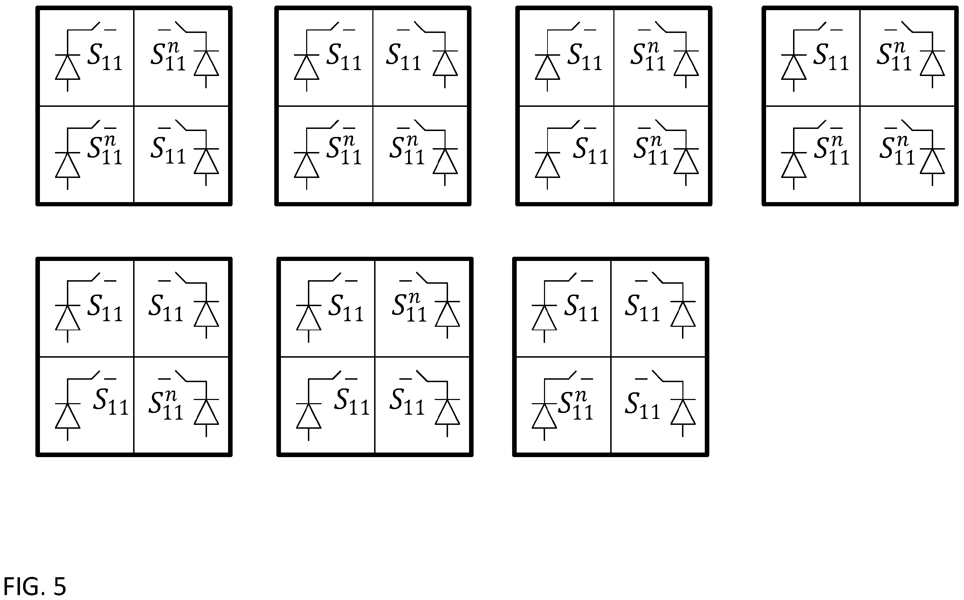

In some embodiments, the pixels of each macro block are controlled by a respective flip flop 305, as illustrated, for example, in FIG. 4D. In the embodiment of FIG. 4D, a flip flop in a first macro block (at top left) receives an input signal from the shutter control signal generator circuit 110 and the output of this flip flop is fed to the four pixels of the first macro block and to the flip flop 305 in the macro block immediately to the right of the first macro block. Some of the pixels of the first macro block may be connected to the output (e.g., the Q output) of the flip flop 305 of the first macro block and some may be connected to the complementary (Q bar) output of the flip flop 305 of the first macro block. For example, to supply, to the pixels of the first macro block, the same set of control signals as those in the embodiment of FIG. 4C, the Q output of the flip flop 305 may be connected to the upper left and lower right pixels of the first macro block, and its complement (the Q bar output of the flip flop 305) may be connected to the upper right and lower left pixels of the first macro block. The embodiment of FIG. 4D is analogous to the embodiment of FIG. 4B in that in both embodiments the control signals are shifted into the pixel array 105 from the shutter control signal generator circuit 110 (in the embodiment of FIG. 4B the control signals are shifted into flip flops 305 in the pixels of each subarray, and in the embodiment of FIG. 4D, the control signals are shifted into flip flops 305 in the macro blocks of each subarray). FIG. 5 illustrates the configurations possible, for a 2 × 2 macro block in which the upper left pixel receives the signal from the flip flop 305 (of the macro block in the embodiment of FIG. 4D, or of the shutter control signal generator circuit 110, in the embodiment of FIG. 4C). Each of the remaining three pixels may receive either the same signal as the upper left pixel, or its complement. Within each subarray, the configurations of the macro blocks may be randomized (during the design phase). Among different subarrays, the macro block configurations may be the same or different. This may increase the randomness of the shutter control, and improve the performance of compressed image reconstruction.

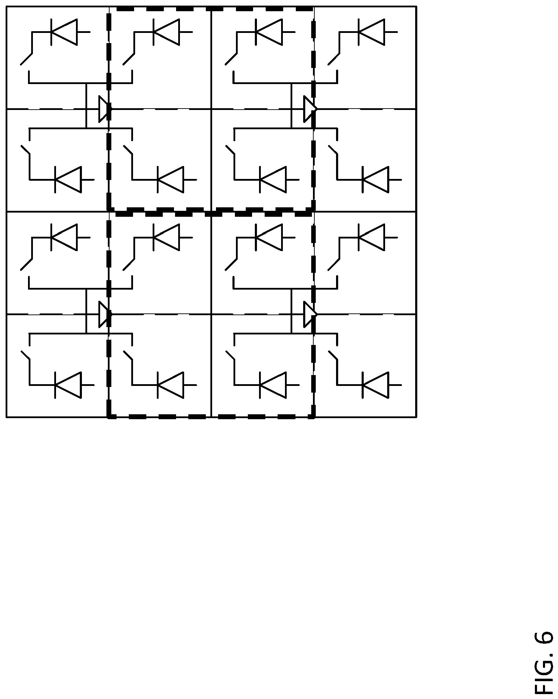

In some embodiments, spatial compression may be achieved in addition to (or instead of) temporal compression, by combining the signals from groups of pixels that may be referred to herein as "pixel readout blocks". FIG. 6 shows an example, in which each pixel readout block includes four pixels (as shown by a readout amplifier in each pixel readout block, each readout amplifier being connected to all four pixels of the pixel readout block). If the shutter control signals are distributed in macro blocks as described above, then each pixel readout block may be coextensive with (e.g., contain the same pixels as) a respective corresponding macro block, or the pixel readout blocks and macro blocks may be different. For example, the pixel readout blocks may be larger than, or smaller than, the macro blocks, or the macro blocks may be offset from the pixel readout blocks. For example, FIG. 6 shows, in heavy dashed lines, two macro blocks that are the same size as, but not coextensive with, the four pixel readout blocks illustrated.

As used herein, a "row" is a $1 \times W$ array of pixels that extends in the width direction of a pixel array 105, and a "column" is a $1 \times H$ array of pixels that extends in the height direction of a pixel array 105. As used herein, the "height" and "width" are two dimensions of the pixel array 105 that may be vertical and horizontal, respectively, or that may be otherwise defined, depending, for example, on the orientation of the pixel array 105. As used herein, a "row" of the pixel array 105 may be a row of pixels or a row of macro blocks. Similarly, a "column" of the pixel array 105 may be a column of pixels or a column of macro blocks.

As used herein, "a portion of" something means "at least some of" the thing, and as such may mean less than all of, or all of, the thing. As such, "a portion of" a thing includes the entire thing as a special case, i.e., the entire thing is an example of a portion of the thing. As used herein, the term "or" should be interpreted as "and/or", such that, for example, "A or B" means any one of "A" or "B" or "A and B".

Each of the terms "processing circuit" and "means for processing" is used herein to mean any combination of hardware, firmware, and software, employed to process data or digital signals. Processing circuit hardware may include, for example, application specific integrated circuits (ASICs), general purpose or special purpose central processing units (CPUs), digital signal processors (DSPs), graphics processing units (GPUs), and programmable logic devices such as field programmable gate arrays (FPGAs). In a processing circuit, as used herein, each function is performed either by hardware configured, i.e., hard-wired, to perform that function, or by more general-purpose hardware, such as a CPU, configured to execute instructions stored in a non-transitory storage medium. A processing circuit may be fabricated on a single printed circuit board (PCB) or distributed over several interconnected PCBs. A processing circuit may contain other processing circuits; for example, a processing circuit may include two processing circuits, an FPGA and a CPU, interconnected on a PCB.

As used herein, when a method (e.g., an adjustment) or a first quantity (e.g., a first variable) is referred to as being "based on" a second quantity (e.g., a second variable) it means that the second quantity is an input to the method or influences the first quantity, e.g., the second quantity may be an input (e.g., the only input, or one of several inputs) to a function that calculates the first quantity, or the first quantity may be equal to the second quantity, or the first quantity may be the same as (e.g., stored at the same location or locations in memory as) the second quantity.

It will be understood that, although the terms "first", "second", "third", etc., may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed herein could be termed a second element, component, region, layer or section, without departing from the spirit and scope of the inventive concept.

Spatially relative terms, such as "beneath", "below", "lower", "under", "above", "upper" and the like, may be used herein for ease of description to describe one element or feature's relationship to another element(s) or feature(s) as illustrated in the figures. It will be understood that such spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to be limiting of the inventive concept. As used herein, the terms "substantially," "about," and similar terms are used as terms of approximation and not as terms of degree, and are intended to account for the inherent deviations in measured or calculated values that would be recognized by those of ordinary skill in the art.

As used herein, the singular forms "a" and "an" are intended to include the plural forms as well, unless the context clearly indicates otherwise. It will be further understood that the terms "comprises" and/or "comprising", when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list. Further, the use of "may" when describing embodiments of the inventive concept refers to "one or more embodiments of the present disclosure". Also, the term "exemplary" is intended to refer to an example or illustration. As used herein, the terms "use," "using," and "used" may be considered synonymous with the terms "utilize," "utilizing," and "utilized," respectively.

It will be understood that when an element or layer is referred to as being "on", "connected to", "coupled to", or "adjacent to" another element or layer, it may be directly on, connected to, coupled to, or adjacent to the other element or layer, or one or more intervening elements or layers may be present. In contrast, when an element or layer is referred to as being "directly on", "directly connected to", "directly coupled to", or "immediately adjacent to" another element or layer, there are no intervening elements or layers present.

Any numerical range recited herein is intended to include all sub-ranges of the same numerical precision subsumed within the recited range. For example, a range of "1.0 to 10.0" or "between 1.0 and 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Similarly, a range described as "within 35% of 10" is intended to include all subranges between (and including) the recited minimum value of 6.5 (i.e., (1 - 35/100) times 10) and the recited maximum value of 13.5 (i.e., (1 + 35/100) times 10), that is, having a minimum value equal to or greater than 6.5 and a maximum value equal to or less than 13.5, such as, for example, 7.4 to 10.6. Any maximum numerical limitation recited herein is intended to include all lower numerical limitations subsumed therein and any minimum numerical limitation recited in this specification is intended to include all higher numerical limitations subsumed therein.

It will be understood that when an element is referred to as being "directly connected" or "directly coupled" to another element, there are no intervening elements present. As used herein, "generally connected" means connected by an electrical path that may contain arbitrary intervening elements, including intervening elements the presence of which qualitatively changes the behavior of the circuit. As used herein, "connected" means (i) "directly connected" or (ii) connected with intervening elements, the intervening elements being ones (e.g., low-value resistors or inductors, or short sections of transmission line) that do not qualitatively affect the behavior of the circuit.

Although exemplary embodiments of a system and method for shutter control have been specifically described and illustrated herein, many modifications and variations will be apparent to those skilled in the art. Accordingly, it is to be understood that a system and method for shutter control constructed according to principles of this disclosure may be embodied other than as specifically described herein within the scope of the appended claims.

## Claims

1. A system, comprising:

   a pixel array for imaging; and
   a shutter control signal generator circuit,
   the shutter control signal generator circuit being configured:

   to control shutters of a first subarray of the pixel array with a first set of control signals, and
   to control shutters of a second subarray of the pixel array with the first set of control signals.

2. The system of claim 1, wherein the shutter control signal generator circuit has h outputs, h being a positive integer, a first one of the h outputs being:

   connected to a first row of the first subarray, and
   connected to a first row of the second subarray.

3. The system of claim 2, wherein:

   the first row of the first subarray is a row of pixels; and
   the first row of the second subarray is a row of pixels.

4. The system of claim 3, wherein:

   the first subarray comprises w flip flops configured as a shift register, w being a positive integer;
   each of the w flip flops is in a respective pixel of a first row of pixels of the first subarray;
   a first flip flop of the w flip flops is connected to an output of the h outputs of the shutter control signal generator circuit; and
   a second flip flop of the w flip flops is connected to an output of the first flip flop.

5. The system of claim 3 or 4, wherein the shutter control signal generator circuit has h × w outputs, w being a positive integer, each of the h × w outputs being connected to:

   a respective pixel of the first subarray, and
   a respective pixel of the second subarray.

6. The system of any one of claims 2 to 5, wherein the first row of the first subarray is a row of macro blocks.

**7.** The system of claim 6, wherein:

the first subarray comprises w flip flops configured as a shift register, w being a positive integer;

each of the w flip flops is in a respective macro block of the first row of the first subarray;

a first flip flop of the w flip flops is connected to an output of the h outputs of the shutter control signal generator circuit; and

a second flip flop of the w flip flops is connected to an output of the first flip flop.

**8.** The system of claim 7, wherein:

a first pixel of a first macro block of the row of macro blocks is configured to receive a first signal; and

a second pixel of the first macro block is configured to receive a second signal, the second signal being a complement of the first signal.

**9.** The system of claim 8, wherein:

the first macro block includes four pixels, and two of the four pixels receive the first signal and two of the four pixels receive the second signal.

**10.** The system of claim 8, wherein:

the first macro block includes four pixels, and three of the four pixels receive the first signal and one of the four pixels receives the second signal.

**11.** The system of claim 6, wherein:

the first row of the second subarray is a row of macro blocks; and

the shutter control signal generator circuit has h × w outputs, w being a positive integer, each of the h × w outputs being connected to:

a respective macro block of the first subarray, and

a respective macro block of the second subarray.

**12.** The system of claim 11, wherein:

a first pixel of a first macro block is connected to an output of the h outputs and configured to receive a first signal, the first signal being equal to an output signal from the output; and

a second pixel is configured to receive a second signal, the second signal being a complement of the first signal.

**13.** The system of claim 12, wherein:

the first macro block includes four pixels, and two of the four pixels receive the first signal and two of the four pixels receive the second signal.

**14.** The system of claim 12, wherein:

the first macro block includes four pixels, and three of the four pixels receive the first signal and one of the four pixels receives the second signal.

**15.** The system of any one of the preceding claims, wherein the pixel array is configured:

to combine outputs of pixels of a pixel readout block comprising a plurality of pixels, and to read out the combined output.

FIG. 1

| h x w random shutter control array | In-pixel shutter control scheme | Pixel array | Read-out scheme |

205    210    105

FIG. 2A

Shutter_n    Shutter    reset

220

FIG. 2B

FIG. 3

FIG. 4A

EP 4 436 049 A1

FIG. 4B

FIG. 4C

$S_{1w}$

305

D

To other
subarrays

305

D

305

D

To other
subarrays

$S_{hw}$

305

D

To other
subarrays

To other
subarrays

FIG. 4D

FIG. 5

FIG. 6

Europäisches
Patentamt

European
Patent Office

Office européen
des brevets

# EUROPEAN SEARCH REPORT

Application Number

EP 24 16 4788

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/070541 A1 (GUICQUERO WILLIAM [FR] ET AL) 12 March 2015 (2015-03-12) | 1-6,15 | INV.<br>H03M7/30<br>H04N25/00<br>H04N25/50 |
| A | * paragraph [0046] - paragraph [0047]; figure 1 *<br>* paragraph [0070] - paragraph [0072] *<br>* paragraph [0108] - paragraph [0110]; figure 5 * | 7-14 | |
| X | US 2018/115725 A1 (ZHANG JIE [US] ET AL) 26 April 2018 (2018-04-26) | 1-6,15 | |
| A | * paragraph [0034] - paragraph [0036]; figure 4 *<br>* paragraph [0050] - paragraph [0051]; figure 12 *<br>* paragraph [0044] - paragraph [0045] * | 7-14 | |
| A | WO 2018/201219 A1 (UNIV BRITISH COLUMBIA [CA]) 8 November 2018 (2018-11-08)<br>* paragraph [0073] - paragraph [0079]; figures 8-9C * | 1-15 | |

|  |
|---|
| TECHNICAL FIELDS SEARCHED (IPC) |
| H03M<br>H04N |

The present search report has been drawn up for all claims

| Place of search | Date of completion of the search | Examiner |
|---|---|---|
| Munich | 18 July 2024 | Dinov, Vassil |

## ANNEX TO THE EUROPEAN SEARCH REPORT
## ON EUROPEAN PATENT APPLICATION NO.

EP 24 16 4788

This annex lists the patent family members relating to the patent documents cited in the above-mentioned European search report.
The members are as contained in the European Patent Office EDP file on
The European Patent Office is in no way liable for these particulars which are merely given for the purpose of information.

18-07-2024

| Patent document cited in search report | Publication date | Patent family member(s) | Publication date |
|---|---|---|---|
| US 2015070541 A1 | 12-03-2015 | EP 2846535 A1 <br> FR 3010602 A1 <br> JP 2015056902 A <br> US 2015070541 A1 | 11-03-2015 <br> 13-03-2015 <br> 23-03-2015 <br> 12-03-2015 |
| US 2018115725 A1 | 26-04-2018 | NONE | |
| WO 2018201219 A1 | 08-11-2018 | NONE | |

EPO FORM P0459

For more details about this annex : see Official Journal of the European Patent Office, No. 12/82